**Europäisches Patentamt**

**European Patent Office**

**Office européen des brevets**

(19)

(11) **EP 1 229 580 A2**

## (12) EUROPEAN PATENT APPLICATION

(43) Date of publication:
**07.08.2002 Bulletin 2002/32**

(51) Int Cl.⁷: **H01L 21/768**

(21) Application number: **02100088.0**

(22) Date of filing: **30.01.2002**

(84) Designated Contracting States:
**AT BE CH CY DE DK ES FI FR GB GR IE IT LI LU MC NL PT SE TR**
Designated Extension States:
**AL LT LV MK RO SI**

(30) Priority: **01.02.2001 US 265857**

(71) Applicant: **Texas Instruments Incorporated Dallas, Texas 75251 (US)**

(72) Inventors:
• **Lu, Jiong-Ping**
  **Richardson TX 75082 (US)**

• **Rose, David J.**
  **Dallas TX 75243 (US)**
• **Chen, Linlin**
  **Plano TX 75025 (US)**

(74) Representative: **Holt, Michael et al**
**Texas Instruments Ltd.,**
**EPD MS/13,**
**800 Pavilion Drive**
**Northampton Business Park,**
**Northampton NN4 7YL (GB)**

(54) **Electrochemical reduction of copper seed for reducing voids in electrochemical deposition**

(57)    An improved method for forming a copper layer (100). After the copper seed layer (116) is formed, any oxidized copper (118) at the surface is electrochemically reduced back to copper rather than being dissolved. Copper (120) is then electrochemically deposited (ECD) over the intact seed layer (116).

FIG. 2D

EP 1 229 580 A2

## Description

FIELD OF THE INVENTION

The present invention is generally related to the field of forming copper interconnects in semiconductor devices and more specifically to electrochemically reducing the copper seed for reducing voids.

BACKGROUND OF THE INVENTION

Copper (Cu) metallization is gaining momentum in replacing aluminum (Al), particularly for the 0.18um technology node and beyond. Due to the difficulty in dry etching Cu, a damascene approach is widely used for Cu metallization. This requires the Cu metallization process to have a high gap fill capability. The sputtering process widely used for Al metallization is not applicable to Cu metallization due to its inherent limitation in step coverage. Chemical vapor deposition (CVD) used in tungsten (W) metallization is not preferred for Cu at this time due to issues with morphology, adhesion and the conformal nature (seam formation issue) of CVD Cu films. Currently, the only manufacturable process for depositing Cu for interconnect applications is electrochemical deposition (ECD), thanks to its bottom-up fill capability.

Electrochemical deposition (ECD) is a process to produce solid phase product (such as thin films) by electrochemical reactions. Cu ECD is a process to make Cu thin film through electrochemical reduction of Cu ion, represented by the following electrochemical equation:

$$Cu^{++} + 2e^- \rightarrow Cu$$

where $e^-$ represents an electron

In order for ECD process to proceed, a copper seed layer is required to pass current and to serve as a nucleation layer. However, the surface condition of the copper seed layer is very difficult to control in a manufacturing environment with prior arts. A copper seed surface exposed to air can readily be oxidized, forming a surface copper oxide layer. The oxide layer degrades the seed-plated Cu interface. Cu oxide also can be dissolved in acidic plating solution. When the copper seed is thin (particularly near the bottom of small device features, such as via and trench), the oxidization and dissolution can cause discontinuity of the seed layer, the major cause of ECD via bottom void. This impacts negatively on via chain yield and device reliability. In addition to seed surface oxidation, Cu seed can also adsorb organic contaminants when exposed to the fab ambient, which degrades surface wettability that can also cause voids in Cu films.

SUMMARY OF THE INVENTION

The present invention provides a method for forming a copper layer. After the copper seed layer is formed, any oxidized copper at the surface is electrochemically reduced back to copper rather than being dissolved. Copper is then electrochemically deposited (ECD) over the intact seed layer.

Furthermore, the present invention provides a method of forming a copper layer that minimizes the formation of voids.

BRIEF DESCRIPTION OF THE DRAWINGS

For a more complete understanding of the present invention, reference is now made to the following detailed description of certain particular and illustrative embodiments and the features and aspects thereof, by way of example only, and with reference to the figures of the accompanying drawings in which:

FIG. 1 is a cross-sectional diagram of a copper interconnect formed according to an embodiment of the invention;

FIGs. 2A-2D are cross-sectional diagrams of the copper interconnect of FIG. 1 at various stages of fabrication; and

FIG. 3 is a graph of voltage versus time comparing air exposed copper to electrochemically reduced copper.

DETAILED DESCRIPTION OF THE EMBODIMENTS

The invention will now be described in conjunction with dual damascene copper interconnect process. It will be apparent to those of ordinary skill in the art having reference to the specification that the benefits of the invention may be applied to ECD copper in general where a reduction of the seed layer surface is desired.

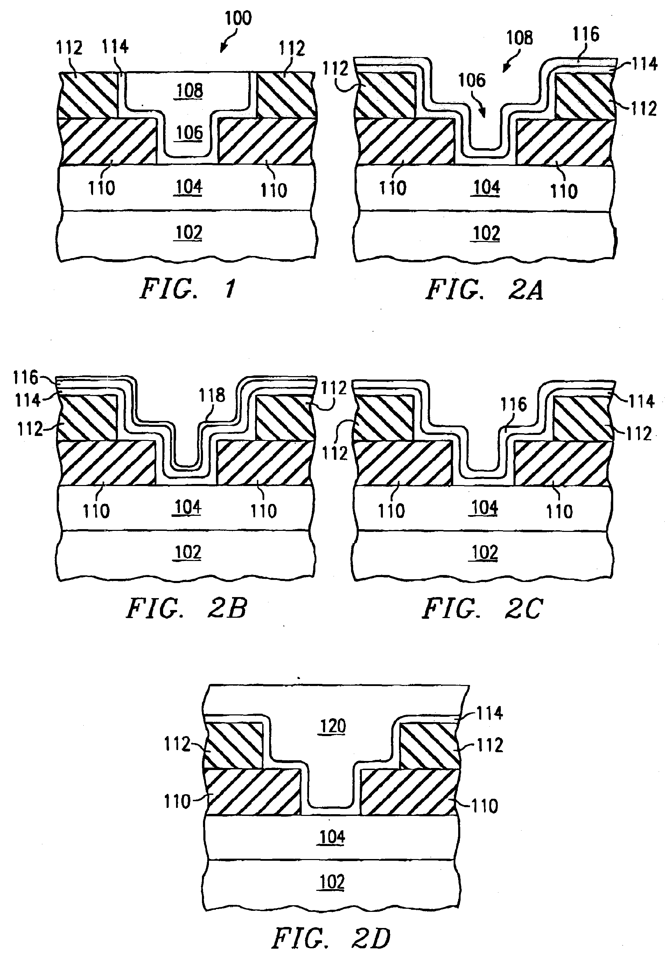

A dual damascene copper interconnect 100 formed according to the invention is shown in FIG. 1. Copper interconnect 100 is formed over semiconductor body 102. Semiconductor body 102 typically has transistors and other devices (not shown) formed therein. Semiconductor body 102 may also include one or more additional metal interconnect layers 104. Copper interconnect 100 comprises a lead portion formed within trench 108 and a via portion formed within via 106. Via 106 extends from the bottom of trench 108 through interlevel dielectric (ILD) 110 to a lower metal interconnect layer 104. Trench 108 is formed within intrametal dielectric (IMD) 112. Various materials are known to be suitable for forming ILD 110 and IMD 112. For example, fluorine-doped silicate glass (FSG), organo-silicate glass (OSG), or other low-k or ultra low-k dielectrics may be used.

A barrier layer 114 is located between the copper interconnect 100 and the trench 108 and via 106 sidewalls. Barrier layer 114 prevents copper from diffusing into the ILD 110 and IMD 112. Barrier layer 114 also provides adhesion between the copper and dielectric. Various barrier layers are known in the art. For example, refractory metals, refractory metal-nitrides, refractory metal-silicon-nitrides, or combinations thereof may be used.

Voids in copper interconnect 100 are minimized or eliminated. Because the invention reduces the copper oxide at the surface of the seed layer (as discussed further below), the seed layer remains continuous. Discontinuities in the seed layer are responsible for the formation of voids in the ECD copper layer. Fewer discontinuities result in fewer voids.

A method of fabricating copper interconnect 100 according to the invention will now be discussed with reference to Figs. 2A-2D. Referring to Fig. 2A, semiconductor body 102 is processed through the formation of one or more metal interconnect layers 104. ILD 110 and IMD 112 are deposited over semiconductor body 102. Suitable materials, such as FSG or OSG, for ILD 110 and IMD 112 are known in the art. Trench 108 is formed in IMD 112 and via 106 is formed in ILD 110, using conventional processing.

Barrier layer 114 is formed over IMD 112 including within trench 108 and via 106. Barrier layer 114 functions as a diffusion barrier to prevent copper diffusion and as an adhesion layer. Transition metals and their nitrides are typically used for barriers. A transition metal-silicon nitride as well as combinations of transition metals, transition metal-nitrides and transition metal-silicon-nitrides may also be used.

Still referring to FIG. 2A, a copper seed layer 116 is deposited over barrier layer 114. Physical vapor deposition is traditionally used to form copper seed layer 116. The copper seed layer 116 is needed to pass current and to serve as a nucleation layer for the copper ECD process.

After deposition of the copper seed layer 116, the wafer is transferred to the ECD tool. A copper seed surface exposed to air can readily be oxidized, forming surface copper oxide layer 118, as shown in FIG. 2B. The oxide layer 118 degrades the seed-plated Cu interface. Cu oxide also can be dissolved in acidic plating solution. When the copper seed is thin (particularly near the bottom of small device features, such as via and trench), the oxidization and dissolution can cause discontinuity of the seed layer, the major cause of ECD via bottom void. Accordingly, after the deposition of a Cu seed layer, the wafer is transferred to an electrochemical cell with an electrolyte solution of high pH (>/= 4). The surface oxide layer is reduced electrochemically by applying cathodic current through the Cu seed layer. The result is shown in FIG. 2C The process can be expressed as follows: $CuO + Xe^- + XH_2O \rightarrow Cu + 2XOH^-$ where e represents electron.

Electrolyte solutions with high pH are used to prevent dissolution of the copper oxide layer before the reduction. The electrolytes can be chosen from the following list: $H_3BO_3 + (CH_3)4NOH$, $H_3BO_3 + Na_2B_4O_7$, $(NR_4)$ $(BF_4)$, $(NR_4)$ $(PF_6)$, where R stands for alkyl group, or other stable electrolytes with pH>4. The waveform and current (voltage) are controlled to make sure only the copper oxide is reduced and hydrogen evolution will not occur. This can be achieved by fixing the total coulomb for the process so the charge passed is only sufficient for copper oxide reduction. Voltage control is preferred in the electrochemical reduction process to ensure no hydrogen evolution occurs while the oxide reduction is complete. Depending on the electrolyte solution (pH numbers are different for different electrolyte solutions) used, a voltage in the range of -0.2 to -1.0V may be used, for example.

After the electroreduction, the wafer is rinsed with deionized water and dried (by spinning and/or blowing an inert gas over the wafer). The rinse/dry process also helps remove surface organic contaminants, in addition to cleaning electrolyte residues. The wafer is then transferred under an inert ambient (such as $N_2$) to the plating cell. The plating cell is preferably in the same cluster tool as the electroreduction cell. Alternatively, it can be performed in a separate machine. The inert ambient is preferred to ensure the reduced surface is not significantly re-oxidized before the plating occurs. If the inert atmosphere cannot be achieved, this approach will still offer an advantage in minimizing the oxide thickness on copper seed.

Once in the plating cell, a copper ECD process is performed. Various copper ECD processes are known in the art. In one example, a 3-step process is used. After placing the wafer in the plating solution, a current of approximately 0.75 Amps is passed through the seed layer for a time on the order of 15 secs. The current is then increased to around 3 Amps for approximately 60 seconds. Final plating occurs at a current of about 7.5Amps with the duration determined by the final desired thickness. A quick spin-rinse dry (SRD) is performed in the plating cell above the plating solution. The wafer is then transferred to the SRD cell and a post-ECD SRD is used to clean the plating residue. The resulting copper layer 120 is shown in Fig. 2D.

After the ECD process, the copper layer 120 (which incorporates seed layer 116) and barrier layer 114 are chemically-mechanically polished to form copper interconnect 100, as shown in Fig. 1. Processing may then continue to form additional metal interconnect layers and to package the device.

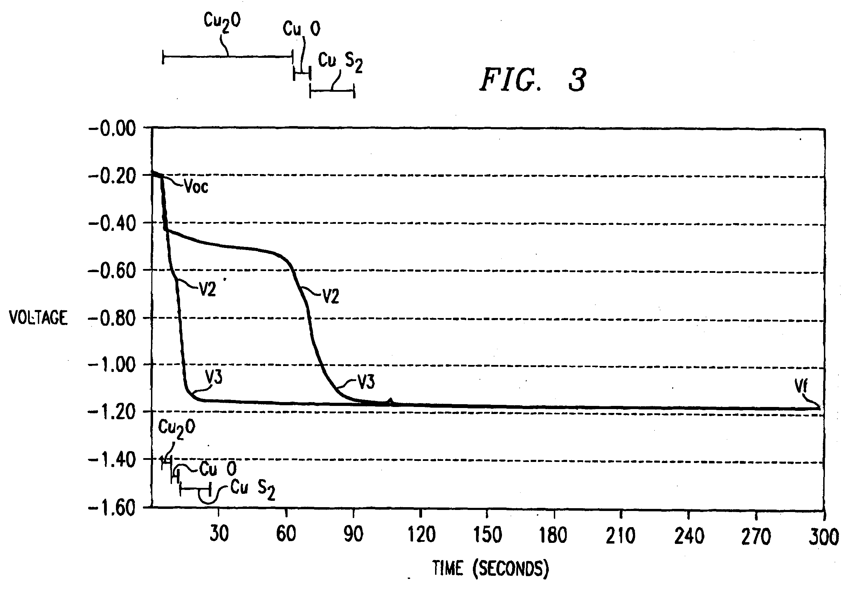

Fig. 3 shows the results of a feasibility test. In this test, a typical copper seed wafer, with approximately 1400Å of copper seed, was determined to have 22Å of $Cu_2O$ and 1Å of CuO on the surface by SERA resulting from exposure of the copper surface to the fab atmosphere. SERA is Sequential Electrochemical Reduction Analysis whereupon the copper oxides are determined by chronopotentiometry employing aqueous buffer solution. After electrochemical reduction of the copper oxides in inert atmosphere employing borate buffer, the SERA scan reveals no $Cu_2O$ or CuO. Thus, the copper oxides on the surface of a copper seed wafer can be reduced electrochemically under inert atmosphere to generate a pristine copper surface just prior to electrochemical deposition of copper. For the sample shown in Fig.3, a sequential electrochemical reduction in the voltage range of -0.4 to -0.8V was used.

While this invention has been described with reference to illustrative embodiments, this description is not intended to be construed in a limiting sense. Various modifications and combinations of the illustrative embodiments, as well as other embodiments of the invention, will be apparent to persons skilled in the art upon reference to the description. For example, the benefits of the invention may be applied to forming the first metal interconnect layer.

**Claims**

1. A method of fabricating an integrated circuit, comprising:

   forming a copper seed layer over a semiconductor body, wherein copper oxide forms at a surface of said copper seed layer
   electrochemically reducing said copper oxide; and
   electrochemically depositing a copper layer on said copper seed layer.

2. The method of claim 1, further comprising:

   rinsing said surface of said copper seed layer after electrochemically reducing said copper oxide and prior to said electrochemically depositing said copper layer.

3. The method of claim 1 or claim 2, further comprising:

   electrochemically reducing said copper oxide and electrochemically depositing said copper layer in the same cluster tool.

4. The method of claim 1 or claim 2, further comprising:

   electrochemically reducing said copper oxide in a first tool; and
   electrochemically depositing said copper layer in a second tool.

5. The method of any preceding claim, further comprising:

   transferring said semiconductor body in an inert atmosphere between said electrochemically reducing step and said electrochemically depositing step.

6. The method of any preceding claim, wherein electrochemically reducing said copper oxide comprises:

   immersing said semiconductor body in an electrolyte having a high pH;
   applying a cathodic current in the copper seed layer during said immersing step to reduce said copper oxide layer;
   removing said semiconductor body from said electrolyte;
   rinsing said semiconductor body with deionized water; and
   transferring said semiconductor body to a plating cell of an electrochemical deposition tool under an inert atmosphere.

7. The method of claim 6, wherein immersing said semiconductor body in said electrolyte comprises:

   immersing said semiconductor body in an electrolyte that is selected from a group consisting of: $H_3BO_3 + (CH_3)4NOH$, $H_3BO_3 + Na_2B_4O_7$, $(NR_4)(BF_4)$, or $(NR_4)(PF_6)$, where R stands for alkyl group.

8. The method of claim 6 or claim 7, wherein immersing said semiconductor body in said electrolyte comprises immersing said semiconductor body in an electrolyte having a pH value greater than 4.

9. The method of any preceding claim, further comprising:

   transferring said semiconductor body in an inert atmosphere between said rinsing step and said electrochemically depositing step.

FIG. 1

FIG. 2A

FIG. 2B

FIG. 2C

FIG. 2D

5

FIG. 3

EP 1 229 580 A2